# EUROPEAN PATENT SPECIFICATION

(11) **EP 1 266 230 B1**
(45) Date of publication and mention of the grant of the patent: **05.05.2010**
(21) Application number: 01924201.5
(22) Date of filing: 16.03.2001
(51) Int. Cl.: G01R 1/073

(54) **METHOD AND APPARATUS FOR PLANARIZING A SEMICONDUCTOR SUBSTRATE IN A PROBE CARD ASSEMBLY**
VERFAHREN UND VORRICHTUNG ZUM EINEBNEN VON EINEM HALBLEITERSUBSTRAT IN EINER TESTKARTENANORDNUNG
PROCEDE ET APPAREIL DE PLANARISATION D'UN SUBSTRAT SEMICONDUCTEUR DANS UNE CARTE À SONDES

(30) Priority: 17.03.2000 US 528064; 17.03.2000 US 527931
(43) Date of publication of application: 18.12.2002
(73) Proprietor: FormFactor, Inc., Livermore, CA 94551 (US)
(72) Inventor: MATHIEU, Gaetan, L., Varennes, QC J3X 1P7 (CA); ELDRIDGE, Benjamin, N., Danville, CA 94526 (US); GRUBE, Gary, W., Pleasanton, CA 94588 (US)
(74) Representative: Harris, Ian Richard
(86) International application number: PCT/US2001/008746
(87) International publication number: WO 2001/071779

(56) References cited:
- WO-A-96/15458
- US-A- 5 094 536

## Description

### BACKGROUND OF THE INVENTION

### Field of the Invention

The present invention relates generally to a probe card assembly, and more specifically to achieving a more planar relationship between the contact elements on a probe card assembly and a device under test.

### Background Information

Individual semiconductor devices (dies) are typically produced by creating several identical devices on a semiconductor wafer, using commonly known techniques such as photolithography and deposition. Generally, these processes are intended to create fully functional integrated circuit devices, prior to separating the individual dies from the semiconductor wafer. However, physical defects in the wafer and defects in the processing of the wafer often lead to the presence of some defective dies on the wafer. It is desirable to be able to identify the defective dies prior to packaging or prior to their separation from the wafer. To perform such identification, wafer testers or probers are used to make pressure connections to connection pads (bond pads) on the dies. The dies can then be tested for defects. A conventional component of a wafer tester is a probe card which has contact elements that effect the pressure connections to the bond pads of the dies.

A probe card can be part of a probe card assembly, such as that which is described in U.S. Patent No. 5,974,662, titled "Method of Planarizing Tips of Probe Elements of a Probe Card Assembly". A probe card assembly according to U.S. Patent No. 5,974,662 typically includes a number of components in addition to the probe card itself, such as an interposer and a space transformer. The interposer is disposed between the probe card and the space transformer and allows the orientation of the space transformer to be adjusted relative to the orientation of the probe card.

The space transformer permits a plurality of contact structures on one side of the space transformer to make contact with the terminals of an electronic component (e.g. bond pads on a semiconductor device) at a relatively fine pitch, while connections to another side of the space transformer are made at a relatively coarser pitch. In a preferred embodiment, the contact structures make contact with an active semiconductor device, such as a wafer. Such connections can be disrupted by slight variations in the planarity of the space transformer. Unfortunately, variations in the planarity of the space transformer can occur, for example, when the space transformer is manufactured. For example, an edge of the space transformer might be bent slightly or the center of the space transformer might be bowed.

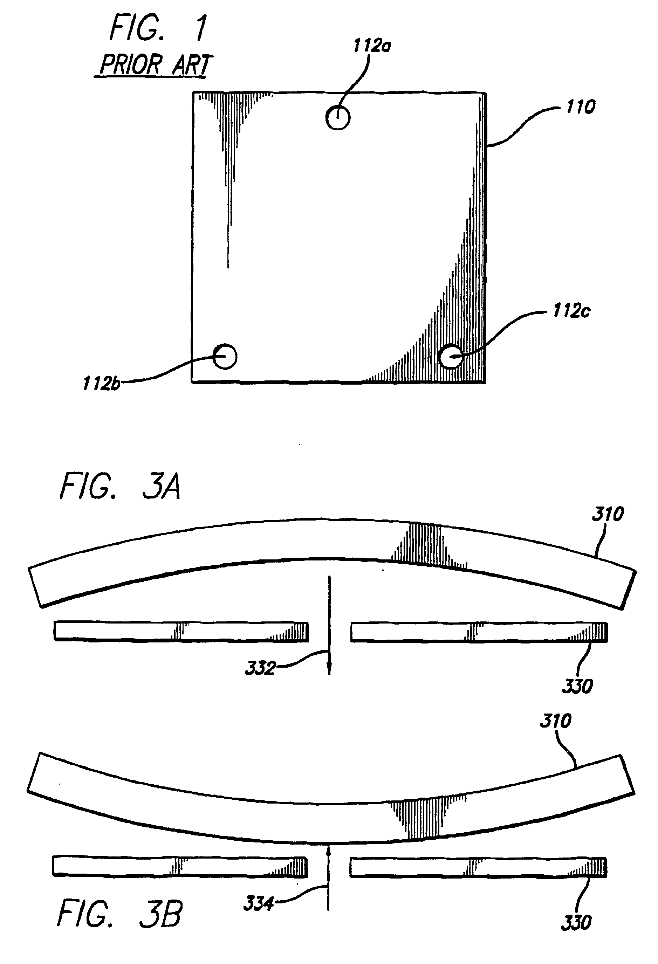

Figure 1 illustrates generally a prior art technique for adjusting the orientation of a space transformer. A space transformer 110 is shown with different sets of adjustment points on the bottom of space transformer 110. In one example, the adjustment points correspond to the locations of ball bearings that can be pressed against a back surface of space transformer 110 to adjust the orientation of space transformer 110. In Figure 1, three adjustment points 112a-112c are used to adjust the orientation of space transformer 110. Adjustment points 112a-112c are located along the periphery of space transformer 110.

The adjustment points shown in Figure 1 can be used to deflect peripheral areas of space transformer 110, but they cannot be used to deflect non-peripheral areas, such as the center, of space transformer 110. The three points of adjustment shown in Figure 1 define a plane which is approximately parallel to the plane of a front surface of space transformer 110. However, because there are only three adjustment points, they can adjust the orientation, but not the shape, of space transformer 110; geometric changes are made on only a low order (1^{st} order polynomial). Furthermore, using ball bearings in conjunction with the adjustment points provides for the application of only a pushing force against space transformer 110, and in some instances, the pushing force is opposed by a spring member on an opposite side of space transformer 110.

In many instances, it is desirable to be able to apply a pulling or pushing force at a multiplicity of locations on a space transformer because the space transformer may require deflection or distortion over its surface to achieve better planarity and correct surface variations.

WO 96/15458 A1 discloses a probe card assembly including a probe card, an interposer, a space transformer and adjustment means for adjusting the orientation (tilt angle) of the space transformer with respect to the probe card. Each adjustment means comprises an inner differential screw element threaded to an outer differential screw element, and the outer screw element is threaded to an actuator mounting plate. After assembly of the probe card assembly 500 the tilt angle of the space transformer can be adjusted by turning the threaded inner or outer screw element.

US-A-5,094,536 relates to the field of lithography and discloses a deformable wafer chuck system. A wafer is positioned onto the chuck on and within a chuck rim and is held in place by a distributed vacuum inside the chuck. A plurality of piezoelectric actuators with pins is located inside the chuck to selectively deform the wafer to cancel a warpage of the wafer.

### SUMMARY OF THE INVENTION

The invention is defined in claims 1 and 10, respectively. Particular embodiments are set out in the dependent claims.

The present invention provides a method of adjusting the planarity of a substrate in a probe card assembly, in which the method includes deflecting at least one of a first area of the substrate, a second area of the substrate, a third area of the substrate, and a fourth area of the substrate, and the deflecting includes applying a pulling force to at least one of the first, second, third and fourth areas of the substrate.

In an embodiment, the method includes creating the substrate with the plurality of contact structures connected to a first surface of the substrate, the contact portions of the contact structures having a first planar relationship relative to one another, and applying a plurality of forces selectively to the substrate to deform the substrate and achieve a second planar relationship of the contact portions of the contact structures relative to one another

The present invention also provides a probe card assembly having a substrate, a plurality of contact elements located on the substrate, and a planarizing member which, when applied to the substrate, is capable of applying a pushing or pulling force at different locations on the substrate to achieve a desired deformation of the substrate.

Preferably, the substrate, which is for use with a probe card assembly, has more than three adjustment points relative to a printed wiring board in the probe card assembly. The adjustment points allow for a plurality of areas of the substrate to be adjusted relative to the printed wiring board and relative to other areas of the substrate.

In an embodiment, the probe card assembly includes a probe card, a substrate, and a first control member extending from the substrate to the probe card. The first control member extends through the probe card and causes the substrate to deflect when the first control member is actuated. In one embodiment, the first control member is coupled to a central area of the substrate.

In an embodiment, a multiplicity of adjustment points on different locations of the substrate facilitate the application of pushing and pulling forces to the substrate.

In an embodiment the multiplicity of adjustment points on different locations of each substrate include the capability for translating and rotation of each substrate relative to one another, as well as facilitating the application of pushing and pulling forces to each of the multiplicity of substrates, are combined in a common assembly to create a larger contact system.

Additional features and benefits of the present invention will become apparent upon review of the following description.

### BRIEF DESCRIPTION OF THE DRAWINGS

Various embodiments of the present invention will be described in detail with reference to the following drawings in which like reference numerals refer to like elements. The present invention is illustrated by way of example and not limitation in the accompanying figures. It should be noted that many of the features shown in the figures have not been drawn to scale for the purpose of better illustrating such features.

Figure 1 illustrates generally a prior art technique for adjusting the planarity of a space transformer in a probe card assembly.

Figure 2 illustrates a cross-sectional view of a probe card assembly in accordance with the teachings of the present invention.

Figures 3A and 3B illustrate generally deflections of a substrate in a probe card assembly in accordance with the teachings of the present invention.

Figure 4A illustrates a bottom view of a probe card assembly in accordance with the teachings of the present invention.

Figure 4B illustrates a bottom view of a substrate in the probe card assembly shown in Figure 4A.

Figures 5A-5C illustrate different embodiments of a planarizing element for a probe card assembly in accordance with the teachings of the present invention.

Figure 6 illustrates multiple adjustable substrates of a probe card assembly.

Figure 7A illustrates a top view of a multiple substrate assembly in accordance with the teachings of the present invention.

Figure 7B illustrates a side view of the multiple substrate assembly shown in Figure 7A.

### DETAILED DESCRIPTION OF THE INVENTION

The following description provides embodiments of the present invention. However, it will be appreciated that other embodiments of the present invention will become apparent to those of ordinary skill in the art upon examination of this description. Thus, the present description and accompanying drawings are for purposes of illustration and are not to be used to construe the invention in a restrictive manner.

In a preferred embodiment of the present invention, a probe card assembly includes a probe card, an interposer, a space transformer, a drive plate and a first control member. The interposer is located between the probe card and the space transformer. The drive plate is located adjacent to the probe card. A protrusion extends from a central area of the bottom surface of the space transformer and through a through hole in the interposer. The first control member is coupled to the protrusion and is disposed within the through hole in the interposer and through holes in the probe card and drive plate. The first control member has an actuating component rotatably coupled to an end of the first control member that is accessible from an exposed side of the drive plate. A spring is supported by the actuating component to be urged against the drive plate. As the actuating component is rotated and moved toward the drive plate, the spring is pressed against the drive plate and provides a resistance to the movement of the actuating component. During this time, the space transformer is pulled toward the interposer via the first control member coupled to the protrusion extending from the space transformer. Thus, a non-peripheral area of the space transformer is deflected according to a preferred embodiment of the present invention.

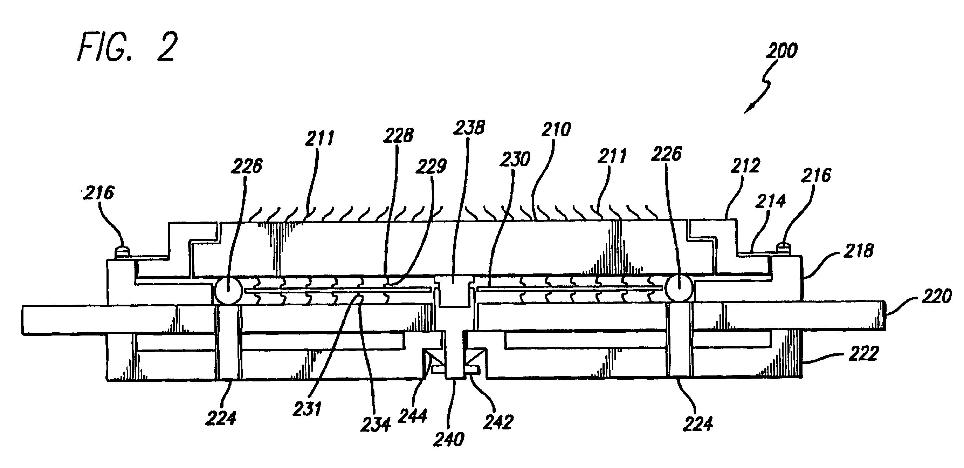

Figure 2 illustrates a side cross-sectional view of a probe card assembly 200 in accordance with the teachings of the present invention. A space transformer 210 is held down at its periphery by a clamping frame 212. The top of space transformer 210 may be substantially flush with the top of frame 212 such that a plurality of resilient contact structures 211 extending from the top of space transformer 210 can extend above the top surface of frame 212.

Contact structures 211 each have a contact region for making contact with the terminals of an electronic component (e.g. bond pads on a semiconductor device). In one embodiment, contact structures 211 are free-standing, springable contact elements. It is appreciated that other contact elements can be used in place of contact structures 211. It is preferred that such elements are sufficiently coupled to space transformer 210 to benefit from the planarizing action associated with the present invention. For example, posts, pins, pads, terminals and bumps/balls or other contact elements known in the art can be used as contact elements.

A clamping spring 214 (e.g. leaf spring) is coupled to a frame 218 by screws 216. Spring 214 secures frame 212. A printed wiring board 220, such as probe card, is located beneath frame 218 and has a through hole in its center and through holes at points around the center in a regular pattern. A drive plate 222, which can also act as a stiffening substrate, is coupled to the bottom of board 220. Drive plate 222 has a set of through holes which align with the through holes in board 220. Screws 224 are placed in the outer through holes in both board 220 and drive plate 222. Ball bearings 226 rest on an end of screws 224 and are pressed against space transformer 210 when screws 224 are screwed toward space transformer 210.

An interposer 230 is located between space transformer 210 and board 220. Interposer 230 has a central through hole. Resilient contact structures 229 extend from the top of interposer 230 and effect pressure connections with contact pads 228 located on space transformer 210. Resilient contact structures 231 extend from the bottom of interposer 230 and effect pressure connections with contact terminals 234 located on board 220. A threaded protrusion or stud 238 extends from the bottom of space transformer 210. Stud 238 may be coupled to space transformer 210 or integrally formed with space transformer 210. An extension stud 240 has a threaded bore in one end which is screwed onto stud 238. The other end of stud 240 is threaded and accommodates an actuating nut 242. Stud 240 is disposed through the central through holes of interposer 230, board 220 and drive plate 222. A spring element 244 (e.g. Belleville washer) is supported by nut 242 and is pressed against drive plate 222 as nut 242 is moved up stud 240.

It is appreciated that a plurality of resilient contact structures can be provided on the bottom surface of a space transformer (e.g. fabricated on the terminals on the bottom surface of a space transformer) to make direct contact to the terminals on the top surface of a printed wiring board. Thus, the use of an interposer is optional. One alternative to an interposer is a semi-rigid support member that backs a flexible sheet incorporating contact structures. The semi-rigid support member, and hence the flexible sheet and contact structures, can be planarized in accordance with the teachings of the present invention. Other alternatives to an interposer include flex tape, pogo pins and other socket or interconnect constructions.

More detailed discussions of printed wiring boards (e.g. probe cards), interposers, space transformers, drive plates, resilient contact structures, contact elements and other components of a probe card assembly that can be used in conjunction with the present invention can be found in U.S. Patent No. 5,974,662, U.S. Patent No. 6,050,829, and U.S. Patent Application No. 09/042, 606, titled "Probe Card Assembly and Kit".

The planarity of space transformer 210 can be adjusted via peripheral control members (e.g. screws 224 and ball bearings 226) and a non-peripheral control member (e.g. stud 240 coupled to stud 238).

For example, screws 224 can be accessed from the bottom side of drive plate 222 to drive them upward and force ball bearings 226 against space transformer 210. Because space transformer 210 is held by frame 212 and spring 214, the contact of ball bearings 226 against space transformer 210 subjects space transformer 210 to compressive forces. Thus, when ball bearings 226 are pressed against space transformer 210, space transformer 210 deflects accordingly. Because ball bearings 226 are located near the periphery of space transformer 210, only peripheral areas of space transformer 210 are adjustable via screws 224 and ball bearings 226. Furthermore, because screws 224 are accessible from an exposed side of drive plate 222, the planarity of peripheral areas of space transformer 210 is remotely adjustable. It should be noted that screws 224 and ball bearings 226 can be used to deflect space transformer 210 without interfering with interposer 230.

A central area of space transformer 210 can be deflected through the actuation of nut 242. As nut 242 is turned and moves up extension stud 240, spring element 244 is pressed against drive plate 222 by nut 242. Spring element 244 provides a resistance to the upward movement of nut 242. Thus, as nut 242 is turned around the threads of stud 240 and urged against spring element 244, stud 240 is pulled down. Because stud 240 is coupled to stud 238, the area of space transformer 210 where stud 238 is located is also pulled down along with stud 240. Thus, such area of space transformer 210 is subjected to a pulling force or tensile force. If space transformer 210 is bowed (e.g. domed), then stud 240 can be pulled down through the actuation of nut 242 to adjust the planarity of space transformer 210. It should be noted that because nut 242 is accessible from an exposed side of drive plate 222, the planarity of a non-peripheral area of space transformer 210 is remotely adjustable. It should be further noted that studs 238 and 240 can be used to deflect space transformer 210 without interfering with interposer 230.

Stud 238 can be located at a variety of positions on the bottom surface of space transformer 210. For example, stud 238 can be located near the center or the edge of the bottom surface of space transformer 210. Thus, it is appreciated that the planarizing apparatus of the present invention can be used to deflect peripheral areas, as well as non-peripheral areas, of a substrate in a probe card assembly. Furthermore, multiple studs can be used. A space transformer can be configured to use a system in which as many as all of the studs or other elements fixed to the space transformer provide pushing and pulling forces through an actuating mechanism to effect the desired deformation of a surface of the space transformer.

Screws 224 and ball bearings 226 cannot be used to pull down a central area of space transformer 210 because they are configured to function with an opposing spring against space transformer 210. The planarizing apparatus of the present invention addresses such a deficiency as described above. Thus, the planarity of space transformer 210 can be more thoroughly adjusted, particularly on a higher order of adjustment (e.g. 2^{nd} order polynomial, 3^{rd} order polynomial, etc.), with the planarizing apparatus of the present invention.

In addition to being able to adjust the planarity of space transformer 210, the planarizing apparatus of the present invention can be used to deflect space transformer 210 such that the contact regions of contact structures 211 are planarized relative to one another. The planarization of the contact regions of contact structures 211 allows more uniform contact to be made with the terminals of an electronic component to facilitate testing of the electronic component. Furthermore, the deflection of space transformer 210 can effect more uniform contact between contact pads 228 and contact structures 229, and between terminals 234 and contact structures 231.

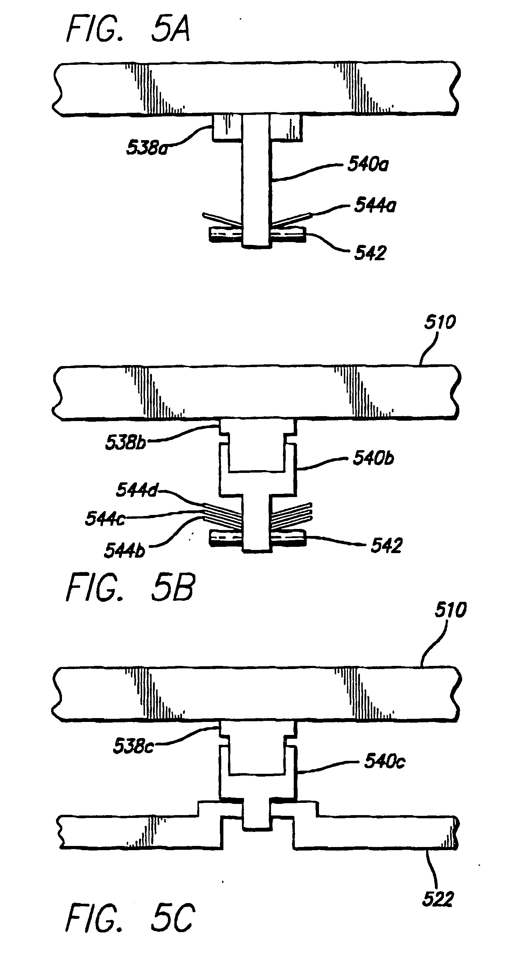

Figures 3A and 3B illustrate generally a bowed substrate 310, such as a space transformer, which is typically located in a probe card assembly. If substrate 310 is bowed as shown in Figure 3A, then a force 332 (e.g. tensile force) which does not directly affect an adjacent interposer 330 can be applied to substrate 310 to pull substrate 310 into a desired position. Specifically, a central area of substrate 310 can be deflected to a desired planarity. Such a pulling force can be applied as previously described in conjunction with Figure 2. If substrate 310 is bowed as shown in Figure 3B, then a force 334 (e.g. compressive force) which does not affect interposer 330 can be applied to substrate 310 to push substrate 310 into a desired position. Specifically, a central area of substrate 310 can be deflected to a desired planarity. Such a pushing force can be applied using an embodiment of the present invention as shown in Figure 5C.

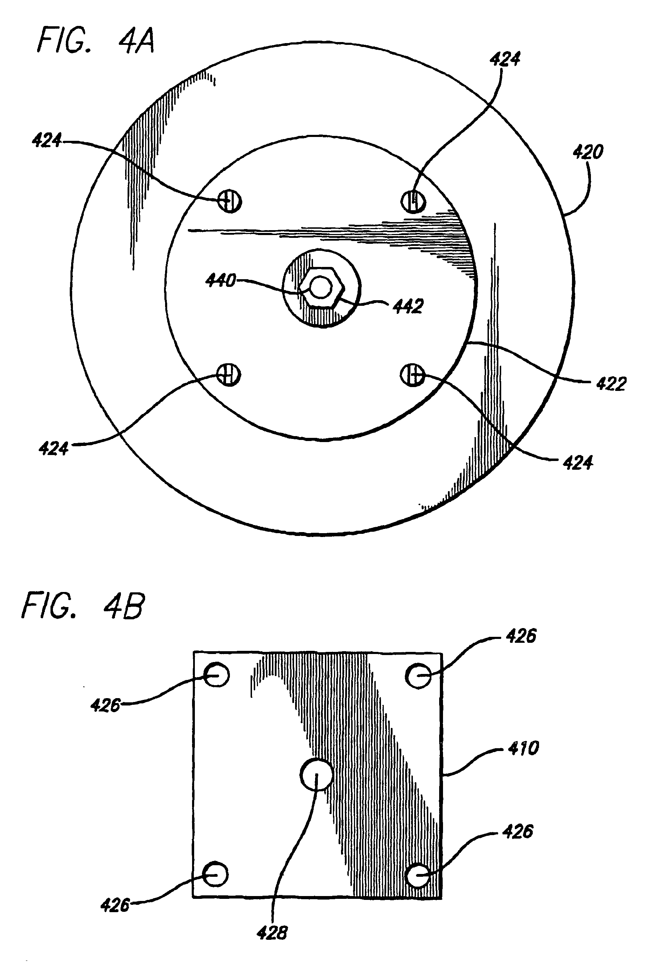

Figure 4A illustrates a bottom view of a probe card assembly fitted with push-only control members 424, which are similar to screws 224, and a push-pull control member 440, which is similar to extension stud 240. A drive plate 422 is coupled to a probe card 420. Both drive plate 422 and probe card 420 have through holes to accommodate control members 424 and 440. Control members 424 drive ball bearings 426 at corresponding locations of a substrate 410, as shown in Figure 4B. Substrate 410, such as a space transformer, is typically part of a probe card assembly such as that shown in Figure 2. A stud 428 extending from the surface of substrate 410 is coupled to central control member 440 to allow a central area of substrate 410 to be deflected by the actuation of a nut 442 relative to control member 440. Control members 424 and 440 can be driven independently to adjust the planarity of substrate 410 in a variety of ways.

Figures 5A-5C illustrate various embodiments of a planarizing apparatus according to the present invention. In Figure 5A, a substrate 510, such as a space transformer, has a stud 538a coupled to or integrally formed with the bottom surface of substrate 510. Stud 538a has a threaded bore to accommodate a connector 540a having threaded ends. A nut 542 coupled to one of the threaded ends of connector 540a supports a spring element 544a, which can be pressed against a substrate (not shown), such as a drive plate, in a manner similar to that described in conjunction with Figure 2. The actuation of nut 542 relative to connector 540a and the resulting resistance provided by spring element 544a help drive connector 540a down, thereby deflecting substrate 510. Spring element 544a is shown as a Belleville washer. It is appreciated that other springs elements, such as coil springs and wavy washers could be used in lieu of a Belleville washer. Furthermore, the spring element could be built into the bottom of the drive plate.

In Figure 5B, substrate 510 has a threaded stud 538b coupled to or integrally formed with the bottom surface of substrate 510. A connector 540b with a threaded bore is coupled to stud 538b. A nut 542 coupled to a threaded end of connector 540b supports spring elements 544b-544d against a substrate (not shown), such as a drive plate. Different spring elements can be used as spring elements 544b-544d to provide varying resistances to nut 542 as nut 542 is twisted along the threads of connector 540b toward space transformer 510.

In Figure 5C, substrate 510 has a threaded stud 538c coupled to or integrally formed with the bottom surface of substrate 510. A connector 540c with a threaded bore is coupled to stud 538c. A threaded end of connector 540c is coupled to a threaded through hole in a substrate 522, such as drive plate. Connector 540c is accessible from an exposed side of substrate 522, which is typically an exterior substrate of a probe card assembly. Connector 540c can be turned clockwise or counter-clockwise to deflect substrate 510 in opposite directions.

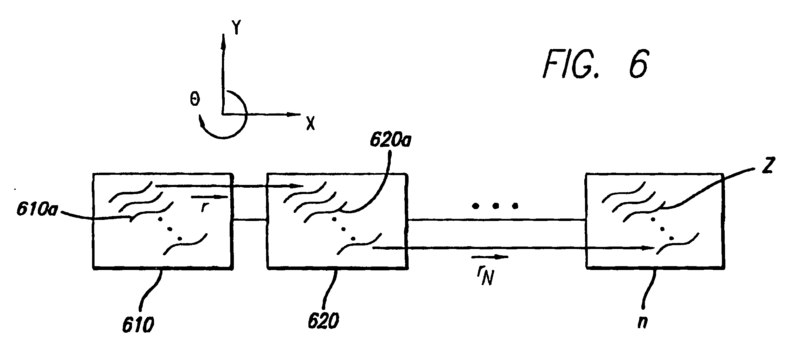

It should be noted that a multipoint adjustment scheme according to the present invention can also be used to modify the orientation (e.g. in x, y and θ directions) of a substrate in a probe card assembly with respect to other substrates in the assembly without interfering with the planarity or orientation of such other substrates. Accordingly, a probe card assembly having multiple deformable substrates may be constructed and made planar across the surface defined by their contact elements with respect to a test substrate, while appropriate positions of the contact elements from substrate to substrate are maintained. Such an assembly is shown generally in Figure 6.

Multiple substrates 610, 620...n are located adjacent to one another in a combined assembly. Each substrate is adjustable with respect to the other substrates in x, y and θ using orienting mechanisms (not shown) well known in the art. A system for deforming substrates in the z direction (out of the page) is also included but is not shown. Such a system may incorporate planarizing elements as disclosed herein. The vector r defines the relationship between corresponding contact elements 610a, 620a...z on multiple substrates 610, 620...n, respectively. Substrates 610, 620...n are positioned with respect to one another such that r is within a desired degree of accuracy, and deformed such that the contact tips of contact elements 610a, 620a...z are coplanar within a desired degree of accuracy in the z direction.

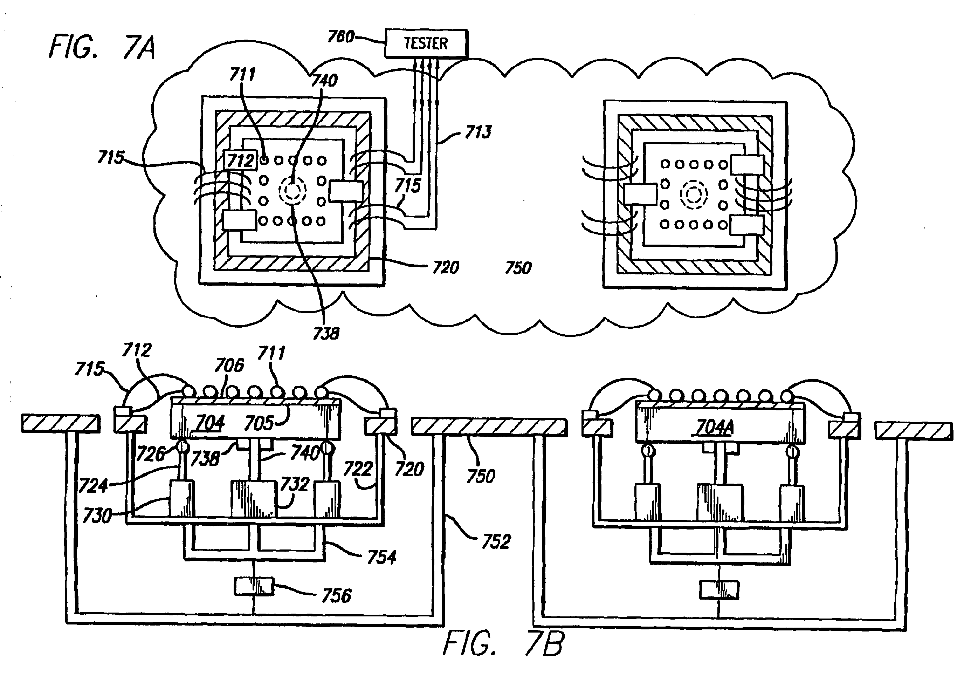

Referring to Figures 7A and 7B, which provide more detailed representations of a combined assembly having multiple substrates similar to that shown in Figure 6, contact elements 711 are secured to insulating support member 705. Contact elements 711 are electrically connected by traces 706 to connecting wires 715, which are connected in turn to traces 713 and to tester 760. Contact elements 711 are illustrated as solder balls but of course can take many of the forms described herein. In one preferred embodiment, connecting wires 715 are portions of a multi-stranded flex cable. In another preferred embodiment, connecting wires 715 can be wirebonded connections. In still another preferred embodiment, insulating support member 705 is polyimide, or other flex materials well known in the art.

Substrate 704 supports insulating support member 705. In one preferred embodiment, they are secured together. In another preferred embodiment, they can be in close contact, but can move relative to each other. Substrate 704 is positioned by a push-only control element comprising actuator 730 acting on element 724 and ball 726 to press against substrate 704, opposed by spring 712, which in turn is secured to substrate frame 720. Several of these push control elements can be used; two are shown in Figure 7B for illustrative purposes. Substrate 704 also is positioned by a push-pull control element comprising actuator 732, element 740, and stud 738, which is secured to substrate 704. Substrate frame 720 is secured to substrate housing 722, which in turn is connected to actuators 730, 732, forming a closed loop system. By selectively positioning the actuators, the shape of substrate 704 can be controlled.

Printed wiring board 750 supports housing 752, which is connected to positioning element 756, which in turn is connected to substrate housing 722 directly or, as shown, through bridge housing 754. Positioning element 756 is illustrated in stylized form and can include elements as desired to provide x, y, z, and three degrees of positional control over substrate housing 722.

Figure 7B illustrates a second substrate 704a as well, with elements as described above. Each substrate 704, 704a can be adjusted to a desired degree of planarity. Equally well, each substrate 704, 704a can be adjusted to a desired degree of flatness of the contact region portion of each of contact elements 711. Moreover, substrates 704 and 704A can be positioned relative to each other to provide a relatively large array of contact elements 711.

Such a probe card assembly constructed of multiple deformable substrates is functionally equivalent to a larger probe card assembly having a much larger (equivalent in area) single substrate. It is important to note that deformation of the monolithic substrate in order to change the spatial relationship of the contact elements residing on it is achieved both by deformation and x, y, z, and θ movement of the multiple substrates and supporting structures in which they reside.

The planarizing apparatus of the present invention can be manually actuated or automatically actuated. For example, an actuator mechanism can be connected to a planarizing apparatus (e.g. to the actuating nut) and operated according to signals from a computer system. A greater number of control points driven by such automated planarizing apparatuses can shape a substrate to a higher degree of accuracy.

Although the present invention has been described with particular reference to probe card assemblies and space transformers in particular, it is appreciated that the present invention is not so limited in its applications.

In the foregoing detailed description, the apparatus and method of the present invention have been described with reference to specific exemplary embodiments. However, it will be evident that various modifications and changes may be made without departing from the broader scope of the present invention. The present specification and figures are accordingly to be regarded as illustrative rather than restrictive.

## Claims

1. A method of adjusting the planarity of a substrate (210, 310, 410, 510) in a probe card assembly (200), the method comprising:
deflecting the substrate (210, 310, 410, 510);
**characterized in that**
deflecting the substrate comprises deflecting at least one of a first area of the substrate (210, 310, 410, 510), a second area of the substrate, a third area of the substrate, and a fourth area of the substrate; and
said deflecting comprises applying a pulling pushing force to said at least one of said first, second, third, and fourth areas of the substrate (210, 310, 410, 510).

2. A method as in claim 1 wherein at least said first area is a non-peripheral area of the substrate (210, 310, 410, 510).

3. A method as in claim 1 wherein said deflecting further comprises applying a pushing force to at least one of said first, second, third, and fourth areas to which said pulling force is not applied.

4. A method as in claim 1 wherein said deflecting is performed manually.

5. A method as in claim 1 wherein said deflecting is performed automatically.

6. Method according to any of claims 1 to 5, wherein a plurality of contact structures (211) are mounted to the substrate (210), the method comprising:
creating the substrate (210) with the plurality of contact structures (211) coupled to a first surface of the substrate (210), the contact portions of the contact structures (211) having a first planar relationship relative to one another;
wherein deflecting at least one of a first area of the substrate (210) comprises:
applying a plurality of forces selectively to the substrate (210) to deform the substrate (210) and achieve a second planar relationship of the contact portions of the contact structures (211) relative to one another.

7. A method as in claim 6 wherein a plurality of substrates (610, 620...n; 704, 704A) are deformed on a combined assembly.

8. A method as in claim 7 wherein a rotational adjustment is performed on at least one of the substrates (610, 620...n; 704, 704A) in said combined assembly.

9. A method as in claim 7 wherein a translational adjustment is performed on at least one of the substrates (610, 620...n; 704, 704A) in said combined assembly.

10. A probe card assembly (200) comprising:
a substrate (210 410, 510) having a first surface, wherein the first surface has an area that includes a central region and at least one peripheral region;
a plurality of contact elements (211) coupled to said first surface of said substrate (210, 410, 510); and
at least one deflection element;
**characterized in that**
the one or each of the at least one deflection elements is a planarizing element capable of transmitting a push/pull force to an area of said substrate (210, 410, 510) to modify a shape of the first surface at said area relative to a shape of said first surface at an other area, whereby, the first surface can be made planar.

11. A probe card assembly as in claim 10 wherein each of said contact elements (211) has a contact region, and wherein said at least one planarizing element applies a push/pull force to the central region relative to each peripheral region such that said contact regions are planarized relative to one another.

12. A probe card assembly as in claim 10 wherein said plurality of contact elements (211) comprises free-standing spring elements.

13. A probe card assembly as in claim 10 further comprising an automated actuator coupled to said at least one planarizing element.

14. A probe card assembly as in claim 10, wherein said at least one planarizing element comprises at least four control elements disposed relative to a printed wiring board (220) in the probe card assembly (200) such that each control element can transmit force to a respective area of said substrate (210) to adjust it relative to said printed wiring board (220).

15. A probe card assembly as in claim 14 wherein said plurality of contact elements (211) are configured to contact a plurality of terminals on a semiconductor device.

16. A probe card assembly as in claim 14 wherein said substrate (210) comprises a space transformer.

17. A probe card assembly as in claim 16 wherein at least one of said control elements comprises:
a stud (240, 540b, 540 c) having a first end and a second end, said first end having a bore mateable with a protrusion (238, 538b, 538 c) on a second surface of said space transformer; and
an actuating component (242, 542) coupled to said second end of said stud (240, 540b, 540 c).

18. A probe card assembly as in claim 17 wherein said actuating component (242, 542) is rotatably coupled to said second end of said stud (240, 540b, 540 c).

19. A probe card assembly as in claim 16 wherein said control elements are controllable by a computer system.

20. An interposer for use with a probe card assembly (200) according to any of claims 10 to 19, **characterized in that** the interposer (230) comprises a non-peripheral opening capable of receiving an actuating assembly for deflecting a space transformer in the probe card assembly (200).

21. Interposer according to claim 20, wherein said opening can be aligned with a central region of a space transformer in the probe card assembly (200), the opening being capable of receiving an actuating assembly for deflecting a central region of a space transformer in the probe card assembly (200) such that a first surface of the space transformer is deflected at said space transformer central region compared to at least one peripheral region of the space transformer.

22. The probe card assembly according to claim 10, wherein said substrate (210, 410, 510) is a space transformer, the probe card assembly further comprising:
an adjustable central control member (240, 440, 540a, 540b, 540c) capable of transmitting a force to the central region of said space transformer (210, 410, 510) to modify a shape of the first surface at said central region relative to a shape of said first surface at each peripheral region; and
at least one adjustable peripheral control member (224, 424), wherein each adjustable peripheral control member is capable of transmitting a respective force to a respective peripheral region of said space transformer (210, 410, 510) to modify a shape of the first surface at the respective peripheral region relative to a shape of said first surface at the central region.

23. The probe card assembly of claim 22, further comprising an interposer (230) coupled to said space transformer (210, 410) and having an opening in a central region of the interposer (230), wherein said adjustable central control member is positioned to extend through the opening in said interposer (230).

24. The probe card assembly of claim 22, wherein said adjustable central control member (240, 440, 540a, 540b, 540c) comprises an adjustable push/pull control member capable of transmitting a push force and a pull force to the central region of said space transformer (210, 410, 510), wherein the push force is a force applied along a direction extending from the push/pull control member toward the space transformer (210, 410, 510), and the pull force is a force applied along a direction extending from the space transformer (210, 410, 510) toward the push/pull control member.

25. The probe card assembly of claim 24, wherein each adjustable peripheral control member (224, 424) comprises an adjustable push control member capable of transmitting a push force to a respective peripheral region of said space transformer (210, 410), wherein the push force is a force applied along a direction extending from the push control member toward the space transformer.

26. The probe card assembly of claim 25, further comprising:
a printed wiring board (220, 420) that is electrically coupled to said space transformer (210, 410); and
a drive plate (222, 422) coupled to said printed wiring board (220 420,);
wherein said adjustable push/pull control member is coupled between said space transformer (210, 410) and said drive plate (222, 422), and each adjustable push control member is coupled between said space transformer (210, 410) and said drive plate (222, 422), whereby, said drive plate (222, 422) helps provide resistance such that said adjustable push/pull control member is capable of pushing and pulling said space transformer (210, 410) away from and toward said drive plate (222, 422) and each adjustable push control member is capable of pushing said space transformer (210, 410) away from said drive plate (222, 422).

27. The probe card assembly of claim 26, wherein said adjustable push/pull control member includes an extension stud (240, 440, 540a, 540b, 540c) having a first end that can be coupled to said space transformer (210, 410, 510) and a second end that can be coupled to said drive plate (222, 422, 522).

28. The probe card assembly of claim 27, wherein said adjustable push/pull control member further includes an actuating element (242, 442, 542) coupled between said second end of said extension stud (240, 540a, 440, 540b, 540c) and said drive plate (222, 422, 522).

29. The probe card assembly of claim 28, wherein said adjustable push/pull control member further includes a spring element (244, 544a, 544b, 544c, 544d)) coupled between said actuating element (242, 542) and said drive plate (222, 522), and wherein said actuating element (242, 542) comprises an actuating nut, whereby, rotation of said actuating nut adjusts the deflection of said space transformer (210, 510).

30. The probe card assembly of claim 26, wherein said adjustable push/pull control member includes an extension stud (540a) having a first threaded end that can be coupled to said space transformer (210, 510) and a second threaded end that can be coupled to said drive plate (222, 522).

31. The probe card assembly of claim 30, further comprising a threaded stud (238, 538a, 538b, 538c) coupled between said space transformer (210, 510) and said first threaded end of said extension stud (240, 540a, 540b, 540c).

32. The probe card assembly of claim 25, wherein at least one of said adjustable push control members includes a screw (224) coupled to a ball bearing (226).

33. The probe card assembly according to any of claims 11 to 19 or 22 to 32 comprising:
a plurality of substrates (610, 620...n; 704, 704A) located adjacent to one another; and
a plurality of planarizing elements that control the planarity of respective ones of said substrates (610, 620...n; 704, 704A) and that control the co-planarity of the plurality of substrates (610, 620...n; 704, 704A).

## Patentansprüche

1. Verfahren zum Einstellen der Ebenheit eines Trägermateriales (210, 310, 410, 510) in einer Testkartenanordnung (200), wobei das Verfahren beinhaltet:
Biegen des Trägermaterials (210, 310, 410, 510),
**dadurch gekennzeichnet, dass**
das Biegen des Trägermateriales das Biegen von zumindest einem ersten Bereich des Trägermateriales (210, 310, 410, 510), einem zweiten Bereich des Trägermateriales, einem dritten Bereich des Trägermateriales oder eines vierten Bereichs des Trägermateriales beinhaltet, und
das Biegen die Anwendung einer Zugkraft/Schubkraft auf den zumindest einen Bereich von dem ersten, zweiten, dritten oder vierten Bereich des Trägermaterials (210, 310, 410, 510) einschließt.

2. Verfahren gemäß Anspruch 1, wobei zumindest der erste Bereich kein Randbereich des Trägermaterials (210, 310, 410, 510) ist.

3. Verfahren gemäß Anspruch 1, wobei das Biegen weiterhin einschließt die Anwendung einer Schubkraft auf wenigstens einen Bereich von den ersten, zweiten, dritten und vierten Bereichen, auf welchen die Zugkraft nicht angewendet wird.

4. Verfahren gemäß Anspruch 1, wobei das Biegen manuell durchgeführt wird.

5. Verfahren gemäß Anspruch 1, wobei das Biegen automatisch durchgeführt wird.

6. Verfahren gemäß einer der Ansprüche 1 bis 5, bei dem eine Vielzahl von Kontaktstrukturen (211) auf dem Trägermaterial (210) angebracht werden, wobei das Verfahren einschließt:
das Ausgestalten des Trägermaterials (210) mit einer Vielzahl von Kontaktstrukturen (211), die an eine erste Oberfläche des Trägermaterials (210) gekoppelt sind, wobei die Kontaktstellen der Kontaktstrukturen (211) eine erste ebene Beziehung relativ zueinander aufweisen,
wobei das Biegen zumindest eines ersten Bereichs eines Trägermaterials (210) einschließt:
die selektive Anwendung einer Mehrzahl von Kräften auf das Trägermaterial (210), um das Trägermaterial (210) zu verformen und eine zweite ebene Beziehung der Kontaktstellen auf den Kontaktstrukturen (211) zueinander zu erzielen.

7. Verfahren gemäß Anspruch 6, wobei eine Vielzahl von Trägermaterialien (610, 620...n; 704, 704A) in einer kombinierten Anordnung verformt werden.

8. Verfahren gemäß Anspruch 7, wobei eine Rotationseinstellung auf zumindest einem der Trägermaterialien (610, 620...n; 704, 704A) in der kombinierten Anordnung angewendet wird.

9. Verfahren gemäß Anspruch 7, wobei eine translationale Einstellung auf zumindest einem der Trägermaterialien (610, 620...n; 704, 704A) in der kombinierten Anordnung angewendet wird.

10. Testkartenanordnung (200), die einschließt:
ein Trägermaterial (210, 410, 510), welches eine erste Oberfläche aufweist, wobei die erste Oberfläche einen Bereich aufweist, der eine zentralen Region und zumindest eine äußere Region einschließt,
eine Vielzahl von Kontaktelementen (211), die an die erste Oberfläche des Trägermateriales (210, 410, 510) gekoppelt sind, und
zumindest ein Biegeelement,
**dadurch gekennzeichnet, dass**
das eine oder jedes des zumindest einen Biegeelements ein planarisierendes Element ist, welches die Schub-/Zugkraft auf einen Bereich des Trägermateriales (210, 410, 510) übertragen kann, um die Form der ersten Oberfläche des besagten Bereiches relativ zu der Form der ersten Oberfläche eines anderen Bereichs zu verändern, wodurch die erste Oberfläche geebnet werden kann.

11. Testkartenanordnung gemäß Anspruch 10, wobei jedes der genannten Kontaktelemente (211) einen Kontaktbereich aufweist, und wobei zumindest ein planarisierendes bzw. ebnendes Element eine Schub-/Zugkraft auf die zentrale Region relativ zu jeder peripheren Region ausübt, so dass die genannten Kontaktbereiche relativ zueinander geebnet werden.

12. Testkartenanordnung gemäß Anspruch 10, wobei die genannte Vielzahl der Kontaktelemente (211) freistehende Federelemente einschließt.

13. Testkartenanordnung gemäß Anspruch 10, die weiterhin einen automatischen Antrieb einschließt, welcher an das zumindest eine ebnende Element gekoppelt ist.

14. Testkartenanordnung gemäß Anspruch 10, wobei das zumindest eine ebnende Element mindestens vier Steuerungselemente einschließt, die relativ zu der gedruckten Leiterplatte (220) in der Testkartenanordnung (200) angeordnet sind, so dass jedes Steuerungselement Kraft auf einen entsprechenden Bereich des Trägermateriales (210) übertragen kann, um ihn relativ zu der gedruckten Leiterplatte (220) einzustellen.

15. Testkartenanordnung gemäß Anspruch 14, wobei die Vielzahl von Kontaktelementen (211) ausgestaltet sind, um Kontakt zu einer Vielzahl von Anschlüssen auf einer Halbleitereinrichtung herzustellen.

16. Testkartenanordnung gemäß Anspruch 14, wobei das Trägermaterial (210) einen Flächenwandler bzw. Spacetransformer einschließt.

17. Testkartenanordnung gemäß Anspruch 16, wobei zumindest eines der Steuerungselemente einschließt:
einen Stift (240, 540b, 540c), der ein erstes und ein zweites Ende aufweist, wobei das erste Ende eine Bohrung (238, 538b, 538c) aufweist, die mit einem Vorsprung auf einer zweiten Oberfläche des Flächenwandler verbindbar ist, und
eine Antriebskomponente (242, 542), die an das zweite Ende des Stiftes (240, 540b, 540c) gekoppelt ist.

18. Testkartenanordnung gemäß Anspruch 17, wobei die Antriebskomponente (242, 542) rotierbar an das zweite Ende des Stiftes (240, 540b, 540c) gekoppelt ist.

19. Testkartenanordnung gemäß Anspruch 16, wobei die Steuerungselemente durch ein Computersystem steuerbar sind.

20. Zwischenschaltung für die Benutzung in einer Testkartenanordnung (200) gemäß einem der Ansprüche 10 bis 19, **dadurch gekennzeichnet, dass** die Zwischenschaltung (230) eine nicht-periphere Öffnung einschließt, welche eine Vorrichtung für das Biegen eines Flächenwandlers in der Testkartenanordnung aufnehmen kann.

21. Zwischenschaltung gemäß Anspruch 20, wobei die genannte Öffnung dem zentralen Bereich des Flächenwandlers in der Testkartenanordnung (200) angepasst werden kann, wobei die Öffnung eine Vorrichtung für das Biegen einer zentralen Region eines Flächenwandlers in der Testkartenanordnung (200) aufnehmen kann, so dass eine erste Oberfläche des Flächenwandlers in dem zentralen Bereich des Flächenwandlers gebogen wird, verglichen mit zumindest einem peripheren Bereich des Flächenwandlers.

22. Testkartenanordnung gemäß Anspruch 10, wobei das Trägermaterial (210, 410, 510) ein Flächenwandler ist und wobei die Testkartenanordnung weiterhin aufweist:
ein verstellbares zentrales Steuerungsglied (240, 440, 540a, 540b, 540c), welches die Kraft zu der zentralen Region des Flächenwandlers (210, 410, 510) übertragen kann, um die Form der ersten Oberfläche in der zentralen Region relativ zu der Form der ersten Oberfläche in jeder peripheren Region zu verändern, und
mindestens ein verstellbares, äußeres Steuerungsglied (224, 424), wobei jedes verstellbare äußere Steuerungsglied eine bestimmte Kraft auf die jeweilige periphere Region des Flächenwandlers (210, 410, 510) ausüben kann, um die Form der ersten Oberfläche der jeweiligen peripheren Region relativ zu der Form der ersten Oberfläche der zentralen Region zu verändern.

23. Testkartenanordnung gemäß Anspruch 22, die weiterhin eine Zwischenschaltung (230) einschließt, die an den Flächenwandler (210, 410) gekoppelt ist und eine Öffnung in dem zentralen Bereich der Zwischenschaltung (230) aufweist, wobei die zentrale Steuereinheit so angebracht ist, dass sie sich durch die Öffnung in der Zwischenschaltung hindurcherstreckt.

24. Testkartenanordnung gemäß Anspruch 22, wobei jede verstellbare äußere Steuerungseinheit (240, 440, 540a, 540b, 540c) eine verstellbare Schub/Zug-Steuerungseinheit einschließt, die eine Schubkraft und eine Zugkraft auf den zentralen Bereich des Flächenwandler (210, 410, 510) ausüben kann, wobei die Schubkraft eine Kraft ist, die in eine Richtung ausgeübt wird, die sich von der Schub/Zug-Steuerungseinheit zu dem Flächenwandler (210, 410, 510) erstreckt, und die Zugkraft eine Kraft ist, die in einer Richtung ausgeübt wird, die sich von dem Flächenwandler (210, 410, 510) zu einer Schub/Zug-Steuerungseinheit erstreckt.

25. Testkartenanordnung gemäß Anspruch 24, wobei jede verstellbare äußere Steuerungseinheit (224, 424) eine verstellbare Schub-Steuerungseinheit einschließt, die eine Schubkraft auf eine entsprechende äußere Region des Flächenwandlers (210, 410) ausüben kann, wobei die Schubkraft eine Kraft ist, die in einer Richtung ausgeübt wird, die sich von der Schub-Steuerungseinheit zu einem Flächenwandler hin erstreckt.

26. Testkartenanordnung gemäß Anspruch 25, die weiterhin einschließt:
gedruckte Leiterplatten (220, 420), die elektrisch an den Flächenwandler (290, 410) gekoppelt sind, und
eine Antriebsplatte (222, 422), die an die genannte Leiterplatte (220, 420) gekoppelt ist,
wobei die genannte Schub/Zug-Steuerungseinheit zwischen den Flächenwandler (210, 410) und die Antriebsplatte (222, 422) geschaltet ist, und jede verstellbare Schub-Steuerungseinheit zwischen den Flächenwandler (210, 410) und die Antriebsplatte (222, 422) gekoppelt ist, wobei die Antriebsplatte (222, 422) einen Widerstand bereitstellt, so dass die verstellbare Schub-/Zug-Steuerungseinheit den Flächenwandler (210, 410) von dort weg und zu der Antriebsplatte (222, 422) schieben und ziehen kann und jede verstellbare Schub-Steuerungseinheit den Flächenwandler von der Antriebsplatte wegschieben kann.

27. Testkartenanordnung gemäß Anspruch 26, wobei die verstellbare Schub/Zug-Steuerungseinheit einen Verlängerungsstift (240, 440, 540a, 540b, 540c) einschließt, der ein erstes Ende aufweist, das an den Flächenwandler (210, 410, 510) gekoppelt werden kann und ein zweites Ende, das an die Antriebsplatte (222, 422, 522) gekoppelt werden kann.

28. Testkartenanordnung gemäß Anspruch 27, wobei die Schub/Zug-Steuerungseinheit weiterhin einschließt ein Antriebselement (242, 442, 542), das zwischen das zweite Ende des Verlängerungsstiftes (240, 540a, 440, 540b, 540c) und die Antriebsplatte gekoppelt ist.

29. Testkartenanordnung gemäß Anspruch 28, wobei die Schub/Zug-Steuerungseinheit weiterhin einschließt ein Federelement (244, 544a, 544b, 544c, 544d), das zwischen das Antriebselement (242, 542) und die Antriebsplatte (222, 522) gekoppelt ist, und wobei das Antriebselement (242, 542) eine Antriebsmutter einschließt und die Rotation der Antriebsmutter das Biegen des genannten einstellt.

30. Testkartenanordnung gemäß Anspruch 26, wobei die Schub/Zug-Steuerungseinheit einen Verlängerungsstift (540a) einschließt, der ein erstes Ende mit einem Gewinde aufweist, das an den Flächenwandler (210, 510) gekoppelt werden kann und ein zweites Ende mit einem Gewinde, das an die Antriebsplatte (222, 522) gekoppelt werden kann.

31. Testkartenanordnung gemäß Anspruch 30, die weiterhin einen Stift mit Gewinde (238, 538a, 538b, 538c) aufweist, der zwischen den Flächenwandler (210, 510) und das erste Gewindeende des Verlängerungsstiftes (240, 540a, 540b, 540c) gekoppelt ist.

32. Testkartenanordnung gemäß Anspruch 25, wobei eine der verstellbaren Schub-Steuerungseinheiten eine Schraube (224) einschließt, die an ein Kugellager (226) gekoppelt ist.

33. Testkartenanordnung gemäß einem der Ansprüche 11 bis 19 oder 22 bis 32, die einschließt:
eine Vielzahl von Trägermaterialen (610, 620...n; 704, 704A), die nebeneinander angeordnet sind, und
eine Vielzahl von ebnenden Elementen, die die Ebenheit der jeweiligen Trägermateriale (610, 620...n; 704, 704A) und die Komplanarität der Vielzahl von Trägermaterialen (610, 620...n; 704, 704A) steuern.

## Revendications

1. Procédé de réglage de la planarité d'un substrat (210, 310, 410, 510) dans un ensemble carte sonde (200), le procédé comprenant l'étape consistant à :
défléchir le substrat (210, 310, 410, 510) ;
**caractérisé en ce que**
l'étape consistant à défléchir le substrat comprend l'étape consistant à défléchir au moins une parmi une première zone du substrat (210, 310, 410, 510), une deuxième zone du substrat, une troisième zone du substrat, et une quatrième zone du substrat ; et
ladite étape consistant à défléchir comprend l'étape consistant à appliquer une force de traction/poussée sur ladite au moins une parmi lesdites première, deuxième, troisième et quatrième zones du substrat (210, 310, 410, 510).

2. Procédé selon la revendication 1, dans lequel au moins ladite première zone est une zone non périphérique du substrat (210, 310, 410, 510).

3. Procédé selon la revendication 1, dans lequel ladite étape consistant à défléchir comprend en outre l'étape consistant à appliquer une force de poussée sur au moins une parmi lesdites première, deuxième, troisième et quatrième zones sur laquelle ladite force de traction n'est pas appliquée.

4. Procédé selon la revendication 1, dans lequel ladite étape consistant à défléchir est réalisée manuellement.

5. Procédé selon la revendication 1, dans lequel ladite étape consistant à défléchir est réalisée automatiquement.

6. Procédé selon une quelconque des revendications 1 à 5, dans lequel une pluralité de structures de contact (211) sont montées sur le substrat (210), le procédé comprenant l'étape consistant à :
créer le substrat (210) avec la pluralité de structures de contact (211) accouplées avec une première surface du substrat (210), les parties de contact des structures de contact (211) possédant une première relation planaire les unes par rapport aux autres ;
dans lequel l'étape consistant à défléchir au moins une d'une première zone du substrat (210) comprend l'étape consistant à :
appliquer une pluralité de forces sélectivement sur le substrat (210) pour déformer le substrat (210) et obtenir une seconde relation planaire des parties de contact des structures de contact (211) les unes par rapport aux autres.

7. Procédé selon la revendication 6, dans lequel une pluralité de substrats (610, 620...n ; 704, 704A) sont déformés sur un ensemble combiné.

8. Procédé selon la revendication 7, dans lequel un réglage de rotation est réalisé sur au moins un des substrats (610, 620...n ; 704, 704A) dans ledit ensemble combiné.

9. Procédé selon la revendication 7, dans lequel un réglage de translation est réalisé sur au moins un des substrats (610, 620...n ; 704, 704A) dans ledit ensemble combiné.

10. Ensemble carte sonde (200) comprenant :
un substrat (210, 410, 510) possédant une première surface, dans lequel la première surface comporte une zone qui comprend une région centrale et au moins une région périphérique ;
une pluralité d'éléments de contact (211) accouplés avec ladite première surface dudit substrat (210, 410, 510) ; et
au moins un élément de déflexion ;
**caractérisé en ce que**
l'un ou chacun du ou des éléments de déflexion est un élément de planarisation capable de transmettre une force de poussée/traction à une zone dudit substrat (210, 410, 510) pour modifier une forme de la première surface dans ladite zone par rapport à une forme de ladite première surface dans une autre zone, moyennant quoi la première surface peut être planarisée.

11. Ensemble carte sonde selon la revendication 10, dans lequel chacun desdits éléments de contact (211) comporte une région de contact, et dans lequel ledit au moins un élément de planarisation applique une force de poussée/traction sur la région centrale par rapport à chaque région périphérique de sorte que lesdites régions de contact soient planarisées les unes par rapport aux autres.

12. Ensemble carte sonde selon la revendication 10, dans lequel ladite pluralité d'éléments de contact (211) comprend des éléments ressorts autonomes.

13. Ensemble carte sonde selon la revendication 10, comprenant en outre un actionneur automatisé accouplé avec ledit au moins un élément de planarisation.

14. Ensemble carte sonde selon la revendication 10, dans lequel ledit au moins un élément de planarisation comprend au moins quatre éléments de commande disposés par rapport à une carte de câblage imprimé (220) dans l'ensemble carte sonde (200) de sorte que chaque élément de commande puisse transmettre une force à une zone respective dudit substrat (210) pour la régler par rapport à ladite carte de câblage imprimé (220).

15. Ensemble carte sonde selon la revendication 14, dans lequel ladite pluralité d'éléments de contact (211) sont configurés pour entrer en contact avec une pluralité de bornes sur un dispositif à semi-conducteur.

16. Ensemble carte sonde selon la revendication 14, dans lequel ledit substrat (210) comprend un transformateur spatial.

17. Ensemble carte sonde selon la revendication 16, dans lequel au moins un desdits éléments de commande comprend :
un goujon (240, 540b, 540c) possédant une première extrémité et une seconde extrémité, ladite première extrémité possédant un alésage pouvant s'accoupler avec une protubérance (238, 538b, 538c) sur une seconde surface dudit transformateur spatial ; et
un composant actionneur (242, 542) accouplé avec ladite seconde extrémité dudit goujon (240, 540b, 540c).

18. Ensemble carte sonde selon la revendication 17, dans lequel ledit composant actionneur (242, 542) est accouplé de façon rotative avec ladite seconde extrémité dudit goujon (240, 540b, 540c).

19. Ensemble carte sonde selon la revendication 16, dans lequel lesdits éléments de commande peuvent être commandés par un système informatique.

20. Élément d'interposition destiné à être utilisé avec un ensemble carte sonde (200) selon une quelconque des revendications 10 à 19, **caractérisé en ce que** l'élément d'interposition (230) comprend une ouverture non périphérique capable de recevoir un ensemble actionneur destiné à défléchir un transformateur spatial dans l'ensemble carte sonde (200).

21. Élément d'interposition selon la revendication 20, dans lequel ladite ouverture peut être alignée avec une région centrale d'un transformateur spatial dans l'ensemble carte sonde (200), l'ouverture étant capable de recevoir un ensemble actionneur destiné à défléchir une région centrale d'un transformateur spatial dans l'ensemble carte sonde (200) de sorte qu'une première surface du transformateur spatial soit défléchie dans ladite région centrale de transformateur spatial par rapport à au moins une région périphérique du transformateur spatial.

22. Ensemble carte sonde selon la revendication 10, dans lequel ledit substrat (210, 410, 510) est un transformateur spatial, l'ensemble carte sonde comprenant en outre :
un élément de commande central réglable (240, 440, 540a, 540b, 540c) capable de transmettre une force à la région centrale dudit transformateur spatial (210, 410, 510) pour modifier une forme de la première surface dans ladite région centrale par rapport à une forme de ladite première surface dans chaque région périphérique ; et
au moins un élément de commande périphérique réglable (224, 424), dans lequel chaque élément de commande périphérique réglable est capable de transmettre une force respective à une région périphérique respective dudit transformateur spatial (210, 410, 510) pour modifier une forme de la première surface dans la région périphérique respective par rapport à une forme de ladite première surface dans la région centrale.

23. Ensemble carte sonde de la revendication 22, comprenant en outre un élément d'interposition (230) accouplé avec ledit transformateur spatial (210, 410) et possédant une ouverture dans une région centrale de l'élément d'interposition (230), dans lequel ledit élément de commande central réglable est positionné pour s'étendre à travers l'ouverture dans ledit élément d'interposition (230).

24. Ensemble carte sonde de la revendication 22, dans lequel ledit élément de commande central réglable (240, 440, 540a, 540b, 540c) comprend un élément de commande de poussée/traction réglable capable de transmettre une force de poussée et une force de traction à la région centrale dudit transformateur spatial (210, 410, 510), dans lequel la force de poussée est une force appliquée le long d'une direction s'étendant à partir de l'élément de commande de poussée/traction vers le transformateur spatial (210, 410, 510), et la force de traction est une force appliquée le long d'une direction s'étendant à partir du transformateur spatial (210, 410, 510) vers l'élément de commande de poussée/traction.

25. Ensemble carte sonde de la revendication 24, dans lequel chaque élément de commande périphérique réglable (224, 424) comprend un élément de commande de poussée réglable capable de transmettre une force de poussée à une région périphérique respective dudit transformateur spatial (210, 410), dans lequel la force de poussée est une force appliquée le long d'une direction s'étendant à partir de l'élément de commande de poussée vers le transformateur spatial.

26. Ensemble carte sonde de la revendication 25, comprenant en outre :
une carte de câblage imprimé (220, 420) qui est accouplée électriquement avec ledit transformateur spatial (210, 410) ; et
une plaque d'entraînement (222, 422) accouplée avec ladite carte de câblage imprimé (220 420) ;
dans lequel ledit élément de commande de poussée/traction réglable est accouplé entre ledit transformateur spatial (210, 410) et ladite plaque d'entraînement (222, 422), et chaque élément de commande de poussée réglable est accouplé entre ledit transformateur spatial (210, 410) et ladite plaque d'entraînement (222, 422), moyennant quoi ladite plaque d'entraînement (222, 422) aide à fournir une résistance de sorte que ledit élément de commande de poussée/traction réglable soit capable de pousser et de tirer ledit transformateur spatial (210, 410) pour l'éloigner et le rapprocher de ladite plaque d'entraînement (222, 422) et chaque élément de commande de poussée réglable soit capable de pousser ledit transformateur spatial (210, 410) pour l'éloigner de ladite plaque d'entraînement (222, 422).

27. Ensemble carte sonde de la revendication 26, dans lequel ledit élément de commande de poussée/traction réglable comprend un goujon d'extension (240, 440, 540a, 540b, 540c) possédant une première extrémité qui peut être accouplée avec ledit transformateur spatial (210, 410, 510) et une seconde extrémité qui peut être accouplée avec ladite plaque d'entraînement (222, 422, 522).

28. Ensemble carte sonde de la revendication 27, dans lequel ledit élément de commande de poussée/traction réglable comprend en outre un élément actionneur (242, 442, 542) accouplé entre ladite seconde extrémité dudit goujon d'extension (240, 540a, 440, 540b, 540c) et ladite plaque d'entraînement (222, 422, 522).

29. Ensemble carte sonde de la revendication 28, dans lequel ledit élément de commande de poussée/traction réglable comprend en outre un élément ressort (244, 544a, 544b, 544c, 544d) accouplé entre ledit élément t actionneur (242, 542) et ladite plaque d'entraînement (222, 522), et dans lequel ledit élément actionneur (242, 542) comprend un écrou actionneur, moyennant quoi la rotation dudit écrou actionneur règle la déflexion dudit transformateur spatial (210, 510).

30. Ensemble carte sonde de la revendication 26, dans lequel ledit élément de commande de poussée/traction réglable comprend un goujon d'extension (540a) possédant une première extrémité filetée qui peut être accouplée avec ledit transformateur spatial (210, 510) et une seconde extrémité filetée qui peut être accouplée avec ladite plaque d'entraînement (222, 522).

31. Ensemble carte sonde de la revendication 30, comprenant en outre un goujon fileté (238, 538a, 538b, 538c) accouplé entre ledit transformateur spatial (210, 510) et ladite première extrémité filetée dudit goujon d'extension (240, 540a, 540b, 540c).

32. Ensemble carte sonde de la revendication 25, dans lequel au moins un desdits éléments de commande de poussée réglables comprend une vis (224) accouplée avec un roulement à billes (226).

33. Ensemble carte sonde selon une quelconque des revendications 11 à 19 ou 22 à 32, comprenant :
une pluralité de substrats (610, 620...n ; 704, 704A) situés de façon adjacente les uns aux autres ; et
une pluralité d'éléments de planarisation qui commandent la planarité de substrats respectifs desdits substrats (610, 620...n ; 704, 704A) et qui commandent la co-planarité de la pluralité de substrats (610, 620...n ; 704, 704A).
